# FASCICULE DE BREVET EUROPEEN

(11) **EP 1 065 766 B1**
(45) Date de publication et mention de la délivrance du brevet: **02.06.2004**
(21) Numéro de dépôt: 00401845.3
(22) Date de dépôt: 28.06.2000
(51) Int. Cl.: H01S 5/14, G02B 5/122

(54) **Composant optique partiellement réfléchissant et source laser incorporant un tel composant**
Teilreflektierendes optisches Bauteil und dessen Verwendung in Laserquellen
Partially reflecting optical component and laser source using the same

(30) Priorité: 30.06.1999 FR 9908400
(43) Date de publication de la demande: 03.01.2001
(73) Titulaire: NETTEST PHOTONICS, 78340 Les Clayes Sous Bois (FR)
(72) Inventeur: Graindorge, Philippe, 21800 Chevigny Saint Sauveur (FR)
(74) Mandataire: Michelet, Alain

(56) Documents cités:
- EP-A- 0 702 438
- EP-A- 0 917 261
- US-A- 5 886 785
- PATENT ABSTRACTS OF JAPAN vol. 006, no. 185 (E-132), 21 septembre 1982 (1982-09-21) & JP 57 099793 A (TOMIJIMA TAKUMI), 21 juin 1982 (1982-06-21)

## Description

La présente invention concerne un composant optique partiellement réfléchissant produisant, à partir d'un faisceau incident, deux faisceaux secondaires, l'un transmis, l'autre réfléchi, et assurant l'auto-alignement à une dimension du faisceau réfléchi avec le faisceau incident, les faisceaux respectivement transmis et réfléchi étant chacun formé de deux demi-faisceaux ayant des fronts d'onde concordants.

En effet, un tel composant présente des avantages significatifs dans de nombreuses applications telles que les sources laser à cavité externe auto-alignée. Or, à la connaissance des inventeurs, un tel dispositif n'a pas encore été conçu, et le problème même de sa réalisation ne paraît pas avoir été posé.

On appelle auto-alignement la propriété d'un système optique pour lequel, les propriétés du flux lumineux sortant sont peu sensibles à l'orientation ou à la position du système par rapport au flux entrant. L'auto-alignement peut être réalisé à deux dimensions, c'est-à-dire dans tous les plans parallèles à la direction du faisceau entrant, ou à une seule dimension, c'est-à-dire dans un seul de ces plans.

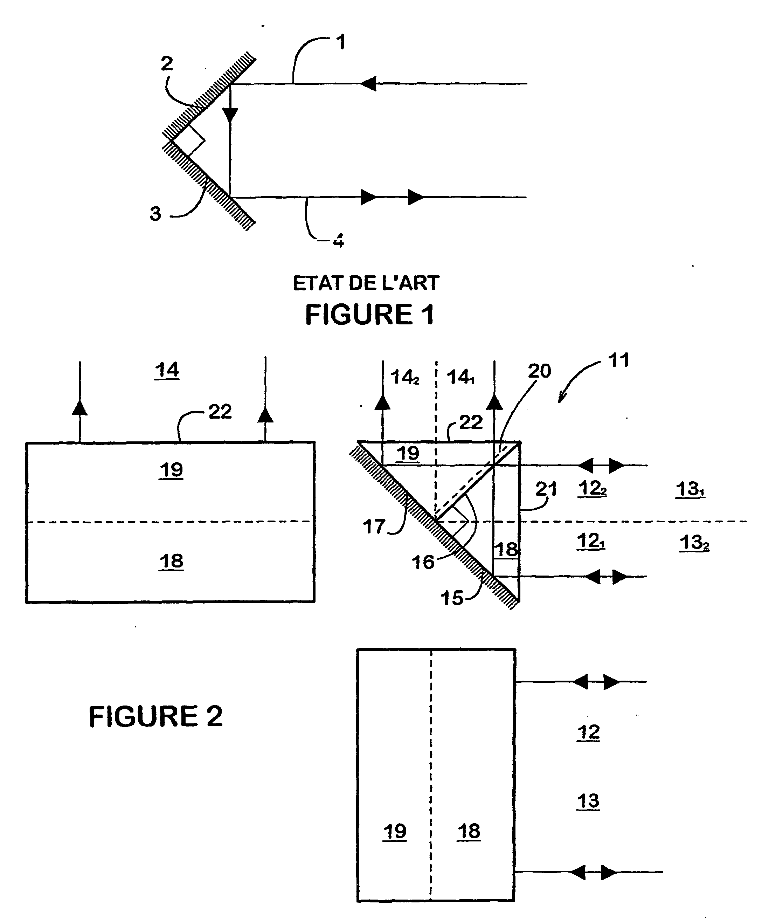

Les demandes de brevets européens EP-A-0 702 438 et EP-A-0 917 261 décrivent une cavité laser utilisant un réflecteur total auto-aligné à une dimension, tel que schématisé sur la figure 1. Ce réflecteur présente deux faces planes réfléchissantes 2 et 3 portées par des miroirs ou par les faces d'un prisme. Un faisceau incident 1 est réfléchi par la face 2 puis par la face 3 et dans la mesure où ces faces sont perpendiculaires, le faisceau émergent 4 est réfléchi dans une direction parallèle avec un sens de propagation opposé à celui du faisceau incident 1.

On connaît également les miroirs partiellement transmetteurs qui sont entre autres utilisés pour assurer l'extraction du flux lumineux de la plupart des cavités laser.

La présente invention permet donc de combiner, dans un composant unique, la fonction de rétroréflexion auto-alignée à une dimension avec la fonction de transmission partielle. Jusqu'à présent, ces deux fonctions étaient réalisées avec des composants différents placés à des positions différentes dans la cavité laser.

Le but de l'invention est donc de proposer un composant unique qui assure à la fois une fonction de réflecteur auto-aligné à une dimension et une fonction de partage du flux incident.

A cet effet, l'invention concerne un composant optique partiellement réfléchissant produisant, à partir d'un faisceau incident, deux faisceaux secondaires, l'un transmis, l'autre réfléchi.

Selon l'invention, le composant optique partiellement réfléchissant comporte :
- une première face plane entièrement réfléchissante et
- une deuxième face plane partiellement réfléchissante, la deuxième face étant perpendiculaire à la première,
- une troisième face plane entièrement réfléchissante,
- les première et troisième faces étant dans le même plan,
- ce composant optique assurant l'auto-alignement à une dimension du faisceau réfléchi avec le faisceau incident, les faisceaux respectivement transmis et réfléchi étant chacun formé de deux demi-faisceaux ayant des fronts d'onde concordants.

Avantageusement, l'invention peut être mise en oeuvre selon les différents modes de réalisation suivants, susceptibles d'être associés selon toutes les combinaisons techniquement possibles et présentant chacune leurs avantages propres :
- la première et la deuxième faces sont les faces d'un même premier prisme, et la troisième face est portée par un deuxième prisme portant une quatrième face au contact de la deuxième face du premier prisme, les deux prismes ont de préférence le même indice de réfraction ;
- le faisceau transmis est renvoyé parallèlement au faisceau incident par une cinquième face entièrement réfléchissante, portée par le deuxième prisme ;
- la cinquième face est parallèle à la deuxième face, le faisceau transmis étant renvoyé en sens contraire du faisceau incident ;
- la cinquième face est parallèle à la troisième face, le faisceau transmis étant renvoyé dans le même sens que le faisceau incident ;
- les premier et deuxième prismes sont fixés l'un à l'autre et forment un bloc unitaire dont les orientations des faces les unes par rapport aux autres sont contrôlées, quel que soit le prisme auquel elles appartiennent ;
- l'une des deuxième et quatrième faces porte un traitement partiellement réfléchissant.

L'invention concerne aussi une source laser à cavité externe comportant un système partiellement réflecteur et auto-aligné à une dimension, tel que précisé plus haut, constituant le système réflecteur auto-aligné et permettant l'extraction d'un flux sortant de la source à la même position dans la source.

Cette source laser à cavité externe peut avantageusement comporter un réseau de diffraction dans la cavité, placé par rapport au réflecteur auto-aligné dans la configuration de Littman-Metcalf. Elle peut être accordable en longueur d'onde et le flux sortant est avantageusement redirigé vers le réseau dans une direction parallèle à l'axe de la cavité. Elle peut aussi être multi-longueur d'onde avec l'utilisation d'une puce semi-conductrice multi-guide.

L'invention sera décrite plus en détail en référence aux dessins annexés dans lesquels :
- la figure 1 est une représentation, en vue de côté, d'un réflecteur total auto-aligné à une dimension de l'art antérieur ;
- la figure 2 est une vue selon trois directions orthogonales d'un composant optique selon l'invention ;
- la figure 3 représente un composant optique selon l'invention renvoyant le flux lumineux extrait dans la direction parallèle et opposée à celle du faisceau incident ;
- la figure 4 représente un composant optique selon l'invention avec renvoi du flux émergent dans une direction parallèle et de même sens que celle du faisceau incident ;
- la figure 5 représente une source laser à cavité externe incorporant le composant optique de l'invention mentionné plus haut, dans une première configuration ;
- la figure 6 représente une source laser à cavité externe incorporant le composant optique de l'invention mentionné plus haut dans une deuxième configuration ;
- la figure 7 représente une source laser à cavité externe incorporant le composant optique de l'invention mentionné plus haut dans une troisième configuration.

La figure 2 est donc une vue d'un composant optique 11 formé de deux prismes droits isocèles rectangles.

Le faisceau incident 12 est décomposé par ce composant optique 11 en deux faisceaux secondaires, l'un 13 réfléchi parallèlement et en sens contraire du faisceau incident 12, et l'autre 14 transmis et renvoyé, ici dans la direction perpendiculaire à celle du faisceau incident 12.

Le composant optique 11 comporte une première face plane 15 entièrement réfléchissante, une deuxième face plane 16 partiellement réfléchissante et perpendiculaire à la première face plane 15.

Il comporte également une troisième face plane 17 entièrement réfléchissante, contenue dans le même plan que la première face plane 15.

Ainsi, le faisceau rétroréfléchi 13 est formé à partir du faisceau incident 12 par deux réflexions successives, respectivement sur ies deux faces 15 ei 16 perpendiculaires du composant 11. Il est connu, et cela a été décrit en référence à la figure 1 que, dans de telles conditions, l'angle formé par le faisceau rétroréfléchi 13 avec le faisceau incident 12 est égal à 180°, étant le double de l'angle de 90° formé par les deux faces 15 et 16. Le faisceau rétroréfléchi 13 est donc renvoyé parallèlement et dans la direction opposée au faisceau 12.

Le faisceau 14 est lui transmis à travers la deuxième face 16 et formé par réflexion sur les première 15 et troisième 17 faces qui sont coplanaires. Lorsque le faisceau incident 12 est incliné à 45° par rapport à la normale au plan formé par les faces planes, respectivement première 15 et troisième 17, le faisceau transmis 14 est perpendiculaire au faisceau incident 12.

Le composant optique 11 remplit ainsi les deux fonctions qui lui sont assignées, c'est-à-dire la production à partir d'un faisceau incident 12, d'une part d'un faisceau réfléchi auto-aligné à une dimension 13 et, d'autre part d'un faisceau transmis 14.

Le rapport d'énergie entre le faisceau 13 et le faisceau 14 dépend du taux de réflexion de la face partiellement réfléchissante 16.

Avantageusement, les première et deuxième faces 15 et 16 sont les faces d'un prisme 18 et la troisième face 17 est portée par un prisme 19 qui a une quatrième face 20 au contact de la deuxième face 16 du premier prisme 18. Les prismes 18 et 19 ont des sections isocèles rectangles. Leurs dernières faces sont respectivement référencées 21 et 22.

Les deux faisceaux émergents 13 et 14 produits par ce composant sont formés de deux demi-faisceaux, chacun en phase avec l'autre, c'est-à-dire que pour le faisceau rétroréfléchi 13, les fronts d'onde des deux demi-faisceaux 13₁ et 13₂ sont concordants. Il en est de même pour les demi-faisceaux 14₁ et 14₂ formant le faisceau extrait 14. Autrement dit, le faisceau d'entrée 12 est découpé par ce composant, les deux demi-faisceaux 12₁ et 12₂ formant respectivement les demi-faisceaux rétroréfléchis 13₁ et 13₂ et les demi-faisceaux transmis 14₁ et 14₂. Les demi-faisceaux 13₁ et 13₂ d'une part, 14₁ et 14₂ d'autre part, sont en phase, leurs fronts d'onde sont concordants, ce qui permet à chacun d'eux de se recoupler efficacement dans une fibre ou un guide d'onde monomode.

Dans certaines applications, il est utile que la direction du faisceau transmis 14 soit parallèle à celle du faisceau incident 12.

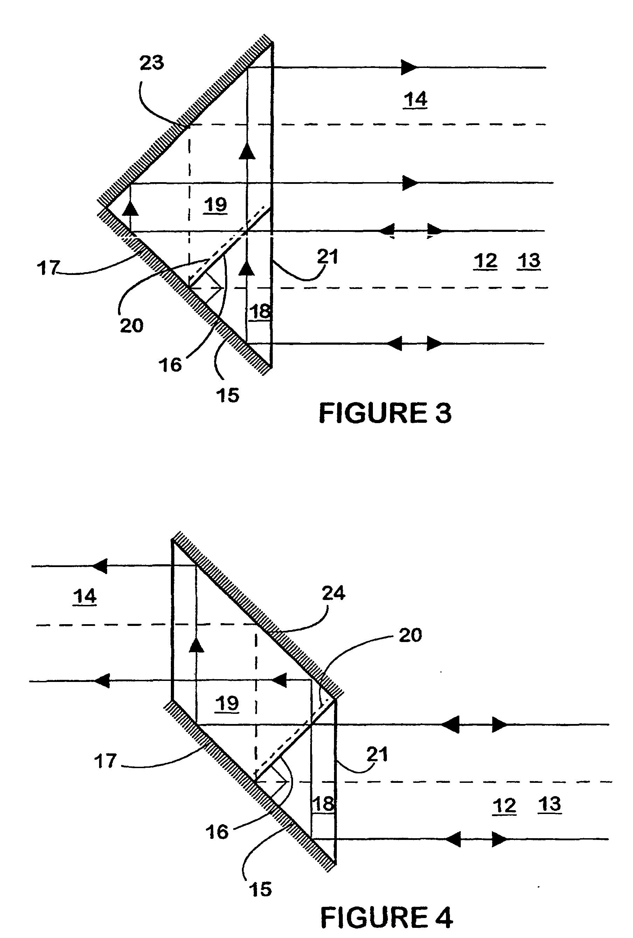

Le composant optique représenté sur la figure 3 permet d'obtenir un tel résultat dans lequel le sens du faisceau extrait 14 est inverse de celui du faisceau incident 12. On retrouve donc sur cette figure les éléments 15 à 21 du prisme représenté sur la figure 2 et une cinquième face 23 solidaire et faisant partie du même prisme que les troisième 17 et quatrième 20 faces, sur laquelle le faisceau émergent 14 est réfléchi une nouvelle fois. Cette face 23 étant parallèle à la deuxième face 16 du composant optique, la direction du faisceau émergent est parallèle et de sens inverse à celle du faisceau incident 12.

De manière analogue et tel que représenté sur la figure 4, ce résultat, c'est-à-dire le parallélisme du faisceau émergent 14 avec le faisceau incident 12, peut être obtenu par la mise en oeuvre d'un deuxième prisme comportant une cinquième face 24 parallèle à la troisième face 17.

Cette face 24, entièrement réfléchissante, étant parallèle à la troisième face 17, le faisceau émergent 14, réfléchi sur cette face 24, est parallèle et de même sens que le faisceau incident 12.

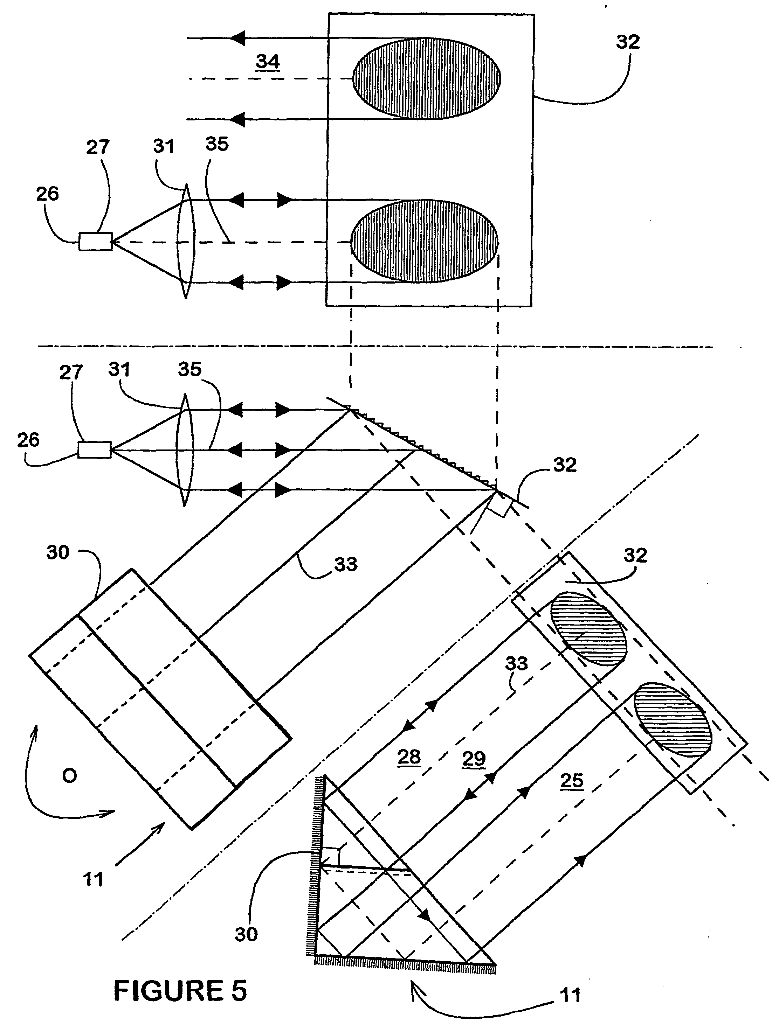

La figure 5 représente de manière schématique l'utilisation du composant optique présenté en référence à la figure 3, globalement désigné par la référence 11, pour l'extraction du flux lumineux de sortie 25 d'une cavité laser. Cette cavité est formée entre la face externe 26 d'une diode laser 27 et le réflecteur partiellement transparent constitué par le composant optique de l'invention 11 et produisant un flux partiellement réfléchi 29 à partir du flux d'entrée 28. On comprend qu'ainsi le composant optique 11 constitue l'équivalent d'une fenêtre partiellement transparente susceptible de constituer la face de sortie d'une cavité laser et en même temps l'équivalent d'un miroir partiellement réfléchissant qui renvoie une partie du faisceau lumineux incident, sur lui-même, avec un auto-alignement dans une dimension, ce qui permet d'assurer une bonne stabilité de la cavité.

Avantageusement, une lentille 31 est placée à l'intérieur de la cavité avec un réseau de diffraction 32 qui est placé par rapport au rétroréflecteur partiel 30, de façon à ce que cet ensemble réseau 32-rétroréflecteur 30 fonctionne dans la configuration de Littman-Metcalf.

On réalise ainsi une source laser particulièrement stable qui peut être accordable comme décrit par ailleurs par la rotation du rétroréflecteur 30, seule ou en combinaison avec le réseau 32 ou encore par le déplacement de la lentille 31. On sait par ailleurs qu'il est possible de contrôler les mouvements respectifs du réseau 32 et du rétroréflecteur 30, de façon à assurer une variation continue de la longueur d'onde d'émission produite par un tel laser.

De plus, le faisceau émergent 25 est renvoyé dans une direction parallèle à l'axe 33 du bras de la cavité laser compris entre le réseau 32 et le rétroréflecteur 30. Cette disposition permet de produire un faisceau de sortie 34 qui a subi un filtrage spectral complémentaire sur le réseau et ce qui permet un filtrage efficace de l'émission spontanée amplifiée résiduelle (ou ASE pour Amplified Spontaneous Emission) de la source laser.

Cette configuration permet de plus de réaliser une anamorphose inverse compensant l'ellipticité du faisceau 25 due à sa production par le réseau 32 qui est incliné par rapport à l'axe 35 du faisceau lumineux dans la cavité entre la diode 27 et le réseau 32. Le faisceau 34 de sortie du laser a donc une taille identique à celle du faisceau 35 de la cavité entre la lentille 31 et le réseau 32, et lui reste parallèle quelle que soit la variation de l'orientation du réseau 31 ou du composant 11. En effet, la longueur d'onde de sortie et celle à l'intérieur de la cavité sont identiques et l'angle entre les faisceaux émis 25 et 34 est identique à celui entre les axes 33 et 35 des faisceaux intra-cavité.

Cette disposition peut donc être mise en place et utilisée pour une source accordable en longueur d'onde où le composant 11 est mobile en rotation car elle permet de maintenir constante la direction du faisceau de sortie après le deuxième passage sur le réseau.

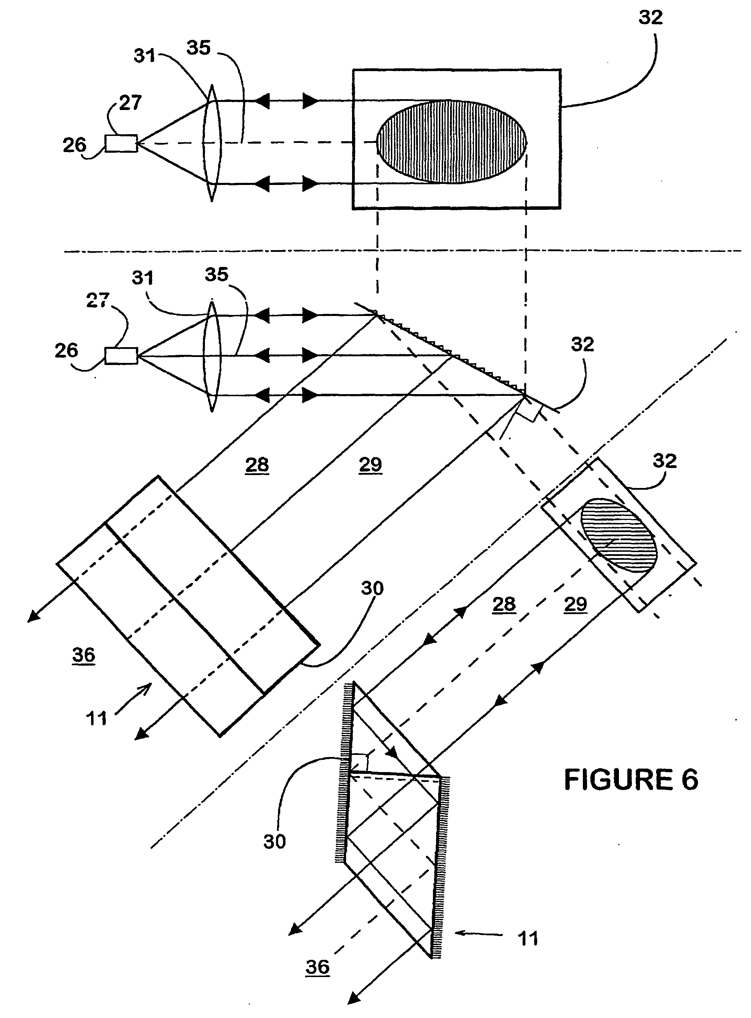

La stabilité de la source ainsi réalisée permet aussi l'exploitation avantageuse du montage représenté sur la figure 6 où les éléments communs à la figure 5 conservent la même numérotation. Le faisceau émis 36 sort toujours parallèle aux faisceaux intracavité 28 et 29 mais ne repasse plus sur le réseau 32.

Cette configuration est particulièrement utile pour la réalisation d'une source multi-longueur d'onde où une puce multi-diode est positionnée à la place de la diode unique 27. On obtient ainsi des flux émergents superposés en direction et en position, quelle que soit leur longueur d'onde.

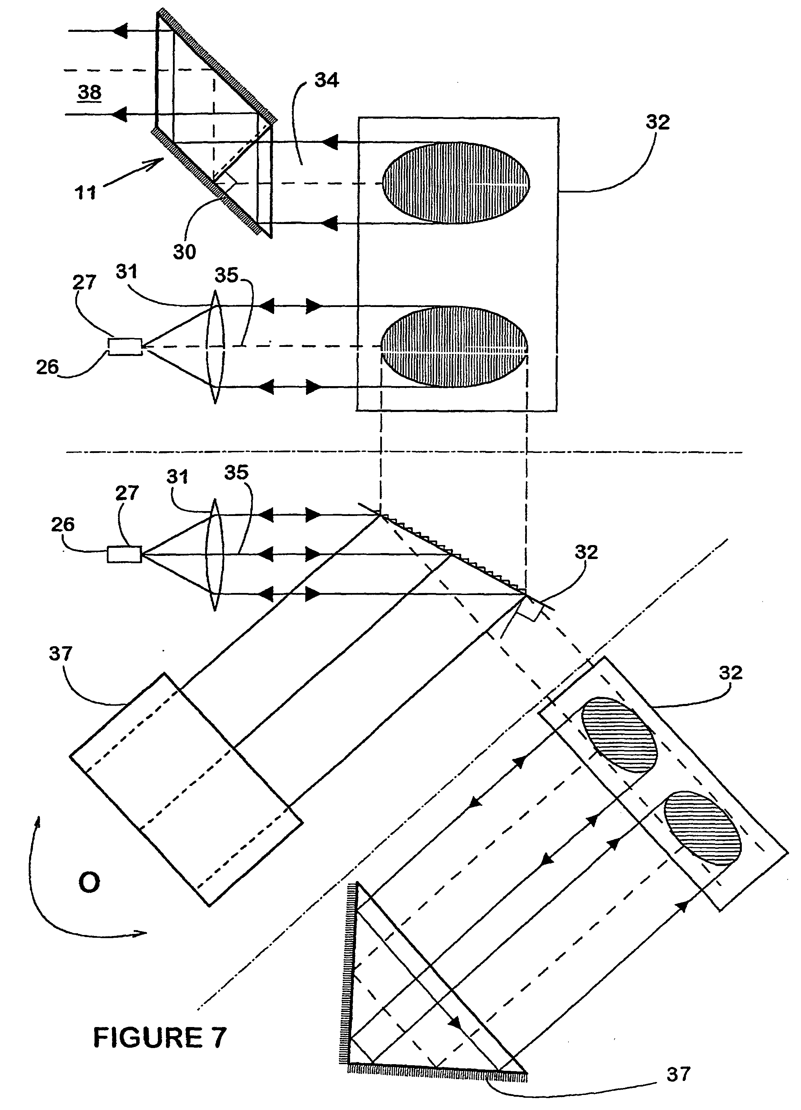

La figure 7 présente un mode de réalisation complémentaire de la configuration de la figure 6 où un dièdre réflecteur additionnel 37 replie la cavité et où le composant 11 de l'invention ferme la cavité après une deuxième diffraction sur le réseau 32.

Le faisceau de sortie 38 est parallèle à l'axe du faisceau 35 intra-cavité et de même dimension, ayant subi une anamorphose inverse après la deuxième diffraction sur le réseau. Cette configuration peut aussi utiliser une puce multi-diode au lieu de la diode unique 27.

## Revendications

1. Composant optique (11) partiellement réfléchissant produisant, à partir d'un faisceau incident (12), deux faisceaux secondaires, l'un réfléchi (13) et l'autre transmis (14),
**caractérisé en ce qu'**il comporte :
- une première face plane (15) entièrement réfléchissante; et
- une deuxième face plane (16) partiellement réfléchissante, la deuxième face étant perpendiculaire à la première;
- une troisième face plane (17) entièrement réfléchissante;
- les première et troisième faces étant dans le même plan;
- ce composant optique assurant l'auto-alignement à une dimension du faisceau réfléchi (13) avec le faisceau incident (12), les faisceaux respectivement transmis (14) et réfléchi (13) étant chacun formé de deux demi-faisceaux ayant des fronts d'onde concordants.

2. Composant optique partiellement réfléchissant selon la revendication 1, **caractérisé en ce que** la première (15) et la deuxième (16) faces sont les faces d'un même premier prisme (18), et que la troisième face (17) est portée par un deuxième prisme (19) portant une quatrième face (20) au contact de la deuxième face (16) du premier prisme.

3. Composant optique partiellement réfléchissant selon la revendication 1 ou 2, **caractérisé en ce que** le faisceau transmis (14) est renvoyé parallèlement au faisceau incident (12) par une cinquième face entièrement réfléchissante, portée par le deuxième prisme (19).

4. Composant optique partiellement réfléchissant selon la revendication 3, **caractérisé en ce que** la cinquième face (23) est parallèle à la deuxième face (16), le faisceau transmis (14) étant renvoyé en sens contraire du faisceau incident (12).

5. Composant optique partiellement réfléchissant selon la revendication 3, **caractérisé en ce que** la cinquième face (24) est parallèle à la troisième face (17), le faisceau transmis (14) étant renvoyé dans le même sens que le faisceau incident (12).

6. Composant optique partiellement réfléchissant selon l'une quelconque des revendications 2 à 5, **caractérisé en ce que** les premier (18) et deuxième (19) prismes sont fixés l'un à l'autre et forment un bloc unitaire dont les orientations des faces les unes par rapport aux autres sont contrôlées, quel que soit le prisme auquel elles appartiennent.

7. Composant optique partiellement réfléchissant selon l'une quelconque des revendications 2 à 6, **caractérisé en ce que** l'une des deuxième (16) et quatrième (20) faces porte un traitement partiellement réfléchissant.

8. Source laser à cavité externe comportant un système réflecteur auto-aligné à une dimension, **caractérisée en ce qu'**elle comporte un composant optique selon l'une des revendications 1 à 7, constituant le système réflecteur auto-aligné à une dimension et permettant à la même position l'extraction d'un flux sortant de la source.

9. Source laser à cavité externe selon la revendication 8, **caractérisée en ce qu'**elle comporte, dans la cavité, un réseau de diffraction placé par rapport au réflecteur auto-aligné, dans la configuration de Littman-Metcalf.

10. Source laser à cavité externe selon la revendication 9, **caractérisée en ce qu'**elle est accordable en longueur d'onde.

11. Source laser à cavité externe selon l'une des revendications 8 à 10, **caractérisée en ce que** la cavité est repliée avec un dièdre réflecteur additionnel et que le réflecteur auto-aligné (11) ferme la cavité après une deuxième diffraction sur le réseau.

12. Source laser à cavité externe selon l'une des revendications 8 à 11, **caractérisée en ce qu'**elle est multi-longueur d'onde.

13. Source laser à cavité externe selon la revendication 10, **caractérisée en ce que** le composant (11) dirige le faisceau transmis sortant (25) vers le réseau selon une direction parallèle à l'axe de la cavité entre le réseau et le réflecteur pour créer un faisceau (34) parallèle au faisceau (35) intracavité.

## Patentansprüche

1. Teilreflektierendes optisches Bauteil (11), das aus einem eintreffenden Strahl (12) zwei Nebenstrahlen, einen reflektierten (13) und einen übertragenen (14), erzeugt,
**dadurch gekennzeichnet, dass** es umfasst:
- eine erste vollreflektierende ebene Fläche (15); und
- eine zweite teilreflektierende ebene Fläche (16), wobei die zweite Fläche zur ersten senkrecht steht;
- eine dritte vollreflektierende ebene Fläche (17);
- wobei sich die erste und die dritte Fläche in derselben Ebene befinden;
- wobei dieses optische Bauteil die eindimensionale Selbstausrichtung des reflektierten Strahls (13) mit dem eintreffenden Strahl (12) sicher stellt, wobei der übertragene Strahl (14) bzw. der reflektierte Strahl (13) jeweils aus zwei halben Strahlen mit übereinstimmenden Wellenfronten gebildet sind.

2. Teilreflektierendes optisches Bauteil nach Anspruch 1, **dadurch gekennzeichnet, dass** die erste (15) und die zweite Fläche (16) die Flächen eines selben ersten Prismas (18) sind, und dass die dritte Fläche (17) an einem zweiten Prisma (19) vorgesehen ist, das eine vierte Fläche (20) in Kontakt mit der zweiten Fläche (16) des ersten Prismas aufweist.

3. Teilreflektierendes optisches Bauteil nach Anspruch 1 oder 2, **dadurch gekennzeichnet, dass** der übertragene Strahl (14) parallel zum eintreffenden Strahl (12) durch eine vollreflektierende fünfte Fläche, die an dem zweiten Prisma (19) vorsehen ist, reflektiert wird.

4. Teilreflektierendes optisches Bauteil nach Anspruch 3, **dadurch gekennzeichnet, dass** die fünfte Fläche (23) parallel zur zweiten Fläche (16) verläuft, wobei der übertragene Strahl (14) in die zum eintreffenden Strahl (12) entgegengesetzte Richtung reflektiert wird.

5. Teilreflektierendes optisches Bauteil nach Anspruch 3, **dadurch gekennzeichnet, dass** die fünfte Fläche (24) parallel zur dritten Fläche (17) verläuft, wobei der übertragene Strahl (14) in dieselbe Richtung wie der eintreffende Strahl (12) reflektiert wird.

6. Teilreflektierendes optisches Bauteil nach einem der Ansprüche 2 bis 5, **dadurch gekennzeichnet, dass** das erste (18) und das zweite Prisma (19) aneinander befestigt sind und einen Einheitsblock bilden, dessen Ausrichtungen der Flächen zueinander kontrolliert werden, unabhängig von dem Prisma, dem sie angehören.

7. Teilreflektierendes optisches Bauteil nach einem der Ansprüche 2 bis 6, **dadurch gekennzeichnet, dass** eine der zweiten (16) und vierten Fläche (20) eine teilreflektierende Behandlung aufweist.

8. Laserquelle mit externem Hohlraum, umfassend ein eindimensional selbst ausgerichtetes Reflexionssystem, **dadurch gekennzeichnet, dass** sie ein optisches Bauteil nach einem der Ansprüche 1 bis 7 umfasst, das das eindimensional selbst ausgerichtete Reflexionssystem bildet und bei derselben Position die Extraktion eines aus der Quelle austretenden Flusses ermöglicht.

9. Laserquelle mit externem Hohlraum nach Anspruch 8, **dadurch gekennzeichnet, dass** sie in dem Hohlraum ein Brechungsnetz aufweist, das in Bezug auf den selbst ausgerichteten Reflektor in der Littman-Metcalf-Konfiguration angeordnet ist.

10. Laserquelle mit externem Hohlraum nach Anspruch 9, **dadurch gekennzeichnet, dass** sie hinsichtlich der Wellenlänge einstellbar ist.

11. Laserquelle mit externem Hohlraum nach einem der Ansprüche 8 bis 10, **dadurch gekennzeichnet, dass** der Hohlraum mit einem zusätzlichen Reflexionsdieder umgeklappt ist und dass der selbst ausgerichtete Reflektor (11) den Hohlraum nach einer zweiten Brechung im Netz schließt.

12. Laserquelle mit externem Hohlraum nach einem der Ansprüche 8 bis 11, **dadurch gekennzeichnet, dass** sie mehrere Wellenlängen besitzt.

13. Laserquelle mit externem Hohlraum nach Anspruch 10, **dadurch gekennzeichnet, dass** das Bauteil (11) den austretenden übertragenen Strahl (25) zu dem Netz entlang einer Richtung parallel zur Achse des Hohlraums zwischen dem Netz und dem Reflektor lenkt, um einen Strahl (34) parallel zum Strahl (35) innerhalb des Hohlraums zu erzeugen.

## Claims

1. A partially reflecting optical component (11) generating, from an incident beam (12), two secondary beams, one of them being reflected (13), the other one being transmitted (14),
**characterized in that** it comprises :
a first wholly reflecting planar face (15) and
a second partially reflecting planar face (16), the second face being perpendicular to the first one,
a third wholly reflecting planar face (17),
the first and third faces being in the same plane,
this optical component providing the unidimensional auto-alignment of the reflected beam (13) with the incident beam (12), the respectively transmitted (14) and reflected (13) beams being each formed with two half-beams having matching wave fronts.

2. A partially reflecting optical component according to claim 1, **characterized in that** the first (15) and the second (16) faces are the faces of a same first prism (18) and **in that** the third face (17) is supported by a second prism (19) bearing a fourth face (20) in contact with the second face (16) of the first prism.

3. A partially reflecting optical component according to claim 1 or 2, **characterized in that** the transmitted beam (14) is sent back parallel to the incident beam (12) by a fifth wholly reflecting face, supported by the second prism (19).

4. A partially reflecting optical component according to claim 3, **characterized in that** the fifth face (23) is parallel to the second face (16), the transmitted beam (14) being sent back in the opposite direction to the incident beam (12).

5. A partially reflecting optical component according to claim 3, **characterized in that** the fifth face (24) is parallel to the third face (17), the transmitted beam (14) being sent back in the same direction as the incident beam (12).

6. A partially reflecting optical component according to any one of claims 2-5, **characterized in that** the first (18) and second (19) prisms are secured to one another and form a unitary block the mutual face orientations of which are controlled, whatever the prism they belong to.

7. A partially reflecting optical component according to any one of claims 2-6, **characterized in that** one of the second (16) and fourth (20) faces has a partially reflecting treatment.

8. An external cavity laser source having a unidimensional auto-aligned reflecting system, **characterized in that** it comprises an optical component according to any one of claims 1-7, forming the unidimensional auto-aligned reflecting system and allowing, at the same position, the extraction of an outgoing flow from the source.

9. An external cavity laser source according to claim 8, **characterized in that** it comprises, within the cavity, a diffraction grating arranged, with respect to the auto-aligned reflector, in the Littman-Metcalf configuration.

10. An external cavity laser source according to claim 9, **characterized in that** it is matchable in wave length.

11. An external cavity laser source according to one of claims 8-10, **characterized in that** the cavity is folded with an additional reflecting dihedral and **in that** the auto-aligned reflector (11) closes the cavity after a second diffraction on the grating.

12. An external cavity laser source according to one of claims 8-11, **characterized in that** it is multi-wave length.

13. An external cavity laser source according to claim 10, **characterized in that** the component (11) directs the outgoing transmitted beam (25) to a grating in a direction parallel to the axis of the cavity between the grating and the reflector to generate a beam (34) parallel to the intra-cavity beam (35).
